# EUROPEAN PATENT APPLICATION

(11) **EP 2 328 096 A1**
(43) Date of publication of application: **01.06.2011**
(21) Application number: 09177386.1
(22) Date of filing: 27.11.2009
(51) Int. Cl.: G06F 15/78, H03K 19/177

(54) **Route-through in embedded functional units**

(71) Applicant: Panasonic Corporation, Kadoma-shi Osaka 571-0051 (JP)
(72) Inventor: Stansfield, Anthony, Bristol, Bristol BS1 6EA (GB)
(74) Representative: Haley, Stephen

(57) **Abstract**

A programmable logic device comprises an array of logic tiles, at least one embedded application specific functional block embedded between a first and a second column of logic tiles, a plurality of local routing networks for connecting adjacent logic tiles together, and at least one altered local routing network for connecting the at least one application-specific functional block to adjacent logic tiles on either side thereof. The at least one altered local routing network comprises a first connecting means for connecting the at least one application-specific functional block to a plurality of logic tiles on either side thereof, a second connecting means for connecting the logic tiles of the first column of logic tiles directly to the logic tiles of the second column of logic tiles and switching means for switching between the first and the second connecting means.

## Description

The present invention relates to the field of user-programmable logic devices. More specifically, the present invention is directed to a routing device for an application-specific functional block embedded within an array of programmable logic tiles.

Reconfigurable devices/fabrics, such as the D-Fabrix architecture (as described in, for example, US6353841, US6252792 and US2002/0157066), are commonly made up of multiple instances of a single user programmable logic tile; the fundamental building block of the system. This arrangement facilitates the use of an easily scalable configuration mechanism of equally regular structure.

Many programmable logic devices supplement the basic array of programmable logic tiles with one or more dedicated application-specific functional blocks. Common examples of such blocks are RAMs and multipliers. Other examples include multiply-accumulate circuits, and even microprocessors.

Typically, these application-specific functional blocks are of a much greater complexity than the simple array of logic tiles which surrounds them, though they are also much faster at performing their dedicated function. In all cases, these dedicated blocks interact with the array of logic tiles and must therefore be connected to them in some way.

In most tile-based reconfigurable devices, each tile is connected to its adjacent tiles by way of a local routing network, and may also be connected to other elements in the device by way of higher-level routing networks. One example of such arrangement can be found in US6252792, which discloses a routing network comprising a hierarchy of bus lengths. Known modern routing networks often also use unidirectional multiplexer-based routing arrangements, such as described in, for example, US7312633.

Known methods of embedding an application-specific functional block into an array of logic tiles comprise the steps of severing the connections between two columns of logic tiles in an array, providing a gap between the adjacent columns of logic tiles, physically inserting the dedicated block(s) into the gap and connecting the terminals of the dedicated block(s) to the local routing network that connects the logic tiles to each other.

One significant disadvantage of this method is that the presence of these dedicated blocks disturbs the regular structure of the reconfigurable array, as the blocks may have different shapes, sizes, and numbers of inputs and outputs from the homogeneous array of tiles.

Accordingly, there exists a problem in finding an efficient way to add arbitrary logic to a reconfigurable array, without severely disturbing the array structure and, in particular, without severely impacting on the routability of applications on the array.

Accordingly, there is a clear need for an improved routing device and method of embedding application specific functional blocks which will reduce the disruption to the homogeneous structure of a reconfigurable array.

In order to solve the problems associated with the prior art, the present invention provides a programmable logic device which comprises:
an array of logic tiles;
at least one embedded application specific functional block embedded between a first and a second column of logic tiles;
a plurality of local routing networks for connecting adjacent logic tiles together;
at least one altered local routing network for connecting the at least one application-specific functional block to adjacent logic tiles on either side thereof, the at least one altered local routing network comprising:
   a first connecting means for connecting the at least one application-specific functional block to a plurality of logic tiles on either side thereof;
   a second connecting means for connecting the logic tiles of the first column of logic tiles directly to the logic tiles of the second column of logic tiles; and
   switching means for switching between the first and the second connecting means.

Preferably, the switching means is a multiplexer.

Preferably, the local routing network is a multi-bit routing network.

The present invention also provides a method of embedding an application specific functional block in an array of logic tiles in a programmable logic device, the programmable logic device comprising an array of logic tiles, at least one application specific functional block positioned between a first and a second column of logic tiles, the application specific functional block having at least one input and at least one output, and a plurality of local routing networks for connecting adjacent logic tiles together, the method comprises the steps of:
extending the local routing networks located between the first and second columns of logic tiles in the array;
connecting the inputs of the application specific functional block to the extended local routing network;
providing switching means, the switching means being arranged to connect at least one input of the logic tiles in the second column of logic tiles to at least one output of the application specific functional block, respectively, and to connect the inputs of the logic tiles in the second column of logic tiles to the outputs of the logic tiles in the first column of logic tiles, respectively.

Preferably, the switching means if a multiplexer.

Preferably, the local routing networks are multi-bit routing networks.

As will be appreciated by a person skilled in the art, the present invention provides several advantages over the prior art. For example, by using the method and apparatus of the present invention, it is possible to effectively embed an application specific functional block in an array of logic tiles without adding a significant amount of extra wiring, and without disrupting the homogeneity of the array when the application-specific functional block(s) is not being used.

An example of the present invention will now be described with reference to the accompanying drawings, in which:
Figure 1 shows a diagram representing a programmable logic device comprised of an array of logic tiles;
Figure 2 shows a diagram representing a programmable logic device comprising embedded application-specific functional blocks;
Figure 3 shows a diagram representing another view of the connections between a row of logic tiles shown in Figure 1 and the local, and higher level, routing networks;
Figure 4 shows a diagram comprising a proposed severing point in the diagram of Figure 3;
Figure 5 shows a diagram representing the result of a prior art method of embedding an application-specific functional block into an array of logic tiles; and
Figure 6 represents an apparatus in accordance with the present invention.

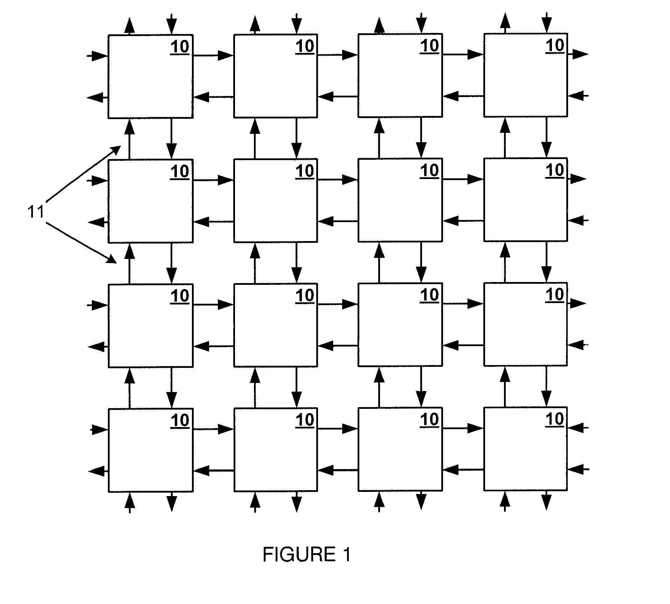

Figure 1 shows a diagram representing a programmable logic device which is made of a plurality of logic tiles 10. Each logic tile 10 contains both processing elements and routing elements (not shown), as described in US6353841. Adjacent tiles are connected together using wired connections 11 to a local unidirectional routing network (not shown). Although the present example shows two unidirectional lines extending between the logic tiles 10, it will be appreciated that these lines represent buses which could width of any number of bits.

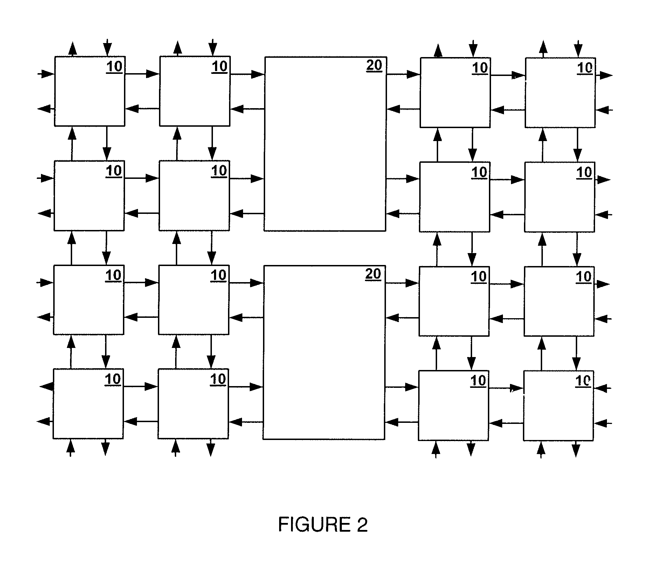

Figure 2 shows a diagram representing two application specific functional blocks 20 embedded in an array of logic blocks 10. As can be seen from Figure 2, the inputs and outputs of the application-specific functional blocks 20 are directly connected to adjacent logic blocks 10 using local unidirectional routing networks (not shown).

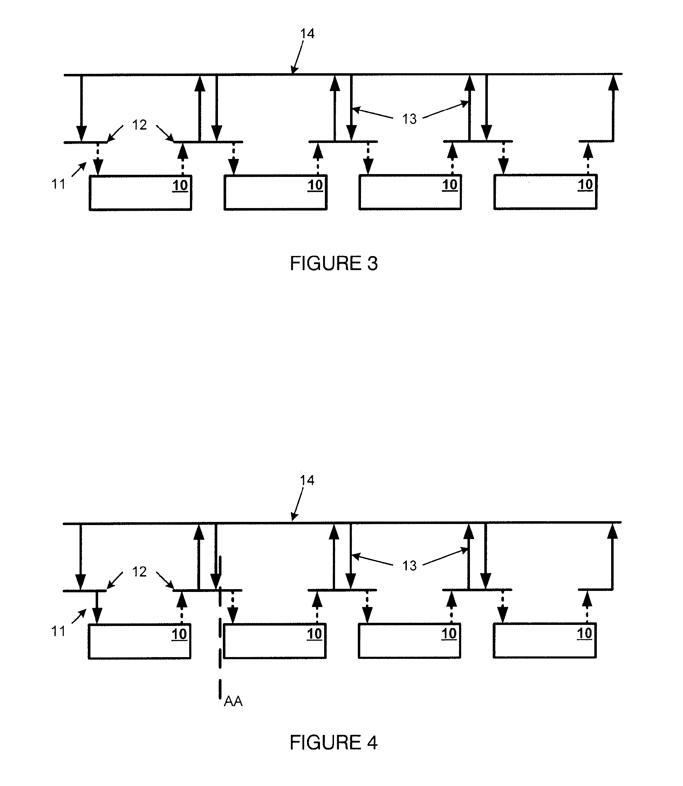

Figure 3 is an alternative view of a single row of logic tiles of the circuit of Figure 1. This view can be considered as a side view, showing a single row of logic blocks, which the routing network extending above it. Each logic tile 10 is connected to a local unidirectional routing network 12 via a wired connection 11. Each local routing network 12 is connected to a high level routing network 14 by way of wired connections 13.

The simplified example of Figure 3 shows a high level network 14 which effectively follows the structure of the array of tiles. In practice, this will not be the case. In several cases, the routing distance between two adjacent tiles in the array is greatly increased by the use of the routing network 14. The quantity of such an increase in routing distance will depend on the architecture of the routing network, as well as the traffic thereon.

Figure 4 shows the circuit of Figure 3 having a severing line AA along which the row of tiles will be severed to allow one or more application specific functional blocks 20 to be embedded. As can be seen, the splitting of the array only affects certain connections (e.g. certain routing network). For example, in the embodiment of Figure 4, the splitting of the array will not affect the high level routing network 14.

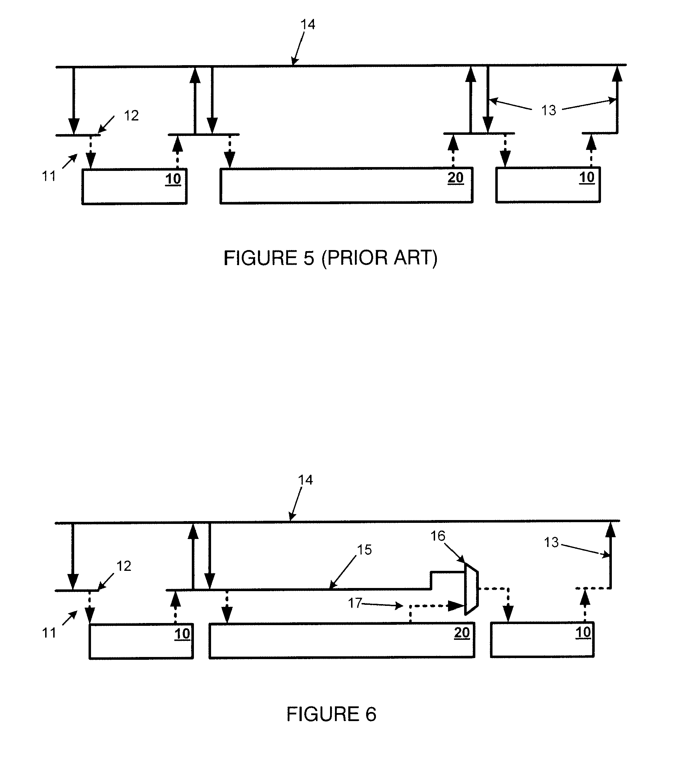

Figure 5 shows a diagram representing the result of a prior art method of embedding an application-specific functional block into an array of logic tiles. As can be seen, the inputs and outputs of the application-specific functional block 20 are directly connected to local routing networks 12, which are in turn, connected to high level routing network 14.

The disadvantage of this circuit is that when information is to be passed from the logic tile 10 on the left of the application specific functional block 20 to logic tile 10 on the right, that information will need to travel via a fist local routing network 12, then through the higher level routing network 14, and then through a second local routing network 12, in order to finally be passed to the second logic tile 10.

Accordingly, using the device of Figure 5, in order to pass information between two logic tiles 10 which were previously adjacent, and which are now separated by an application-specific functional block 20, it is necessary to make use of the high level routing network. This extra distance will decrease the operational speed of the programmable logic device. Such decreases in performance can be exacerbated by traffic in the high level network 14, as well as the architecture of the high level network itself.

The present invention is shown in Figure 6. As can be seen, the local routing network attached to the logic tile 10 on the left side of the application specific functional block 20 is lengthened in order to form an extended local routing network 15 which can span the breadth of the application specific functional block 20. The output of the application-specific functional block 20 is connected to a first input of the multiplexer 16. The extended local routing network 15 is connected to a second input of multiplexer 16. As will be appreciated, the multiplexer can be replaced with any other suitable switching means.

The output of the multiplexer is connected to the input of the logic tile 10 situated on the right side of the application-specific functional block 20. The multiplexer can be controlled in any number of know ways, including having a dedicated input memory bit, or being connected to a register within the array of tiles.

In operation, the multiplexer 16 is switched into one of two states. In the first state, the output of the logic tile 10 on the left side of the application specific functional block 20 is connected to the input of the application specific functional block, via the extended local routing network 15. Also in this first state, the output of the application specific functional block 20 is connected to the input of the logic tile 10 on the right side of the application specific functional block 20, via the multiplexer 16. In the second state, the output of the logic tile 10 on the left side of the application specific functional block 20 is connected to the input of the input of the logic tile 10 on the right side of the application specific functional block 20, via the extended local routing network 15 and the multiplexer 16.

## Claims

1. A programmable logic device comprising:
an array of logic tiles (10);
at least one embedded application specific functional block (20) embedded between a first and a second column of logic tiles;
a plurality of local routing networks (12) for connecting adjacent logic tiles together;
at least one altered local routing network (15, 16) for connecting the at least one application-specific functional block to adjacent logic tiles on either side thereof, the at least one altered local routing network comprising:
a first connecting means for connecting the at least one application-specific functional block to a plurality of logic tiles on either side thereof;
a second connecting means for connecting the logic tiles of the first column of logic tiles directly to the logic tiles of the second column of logic tiles; and
switching means for switching between the first and the second connecting means.

2. The programmable logic device of claim 2, wherein switching means is a multiplexer.

3. The programmable logic device of any of the preceding claims, wherein the local routing network is a multi-bit routing network.

4. A method of embedding an application specific functional block in an array
of logic tiles in a programmable logic device, the programmable logic device comprising an array of logic tiles (10), at least one application specific functional block (20) positioned between a first and a second column of logic tiles, the application specific functional block having at least one input and at least one output, and a plurality of local routing networks (12) for connecting adjacent logic tiles together, the method comprising the steps of:
extending the local routing networks located between the first and second columns of logic tiles in the array;
connecting the inputs of the application specific functional block to the extended local routing network;
providing switching means, the switching means being arranged to connect at least one input of the logic tiles in the second column of logic tiles to at least one output of the application specific functional block, respectively, and to connect the inputs of the logic tiles in the second column of logic tiles to the outputs of the logic tiles in the first column of logic tiles, respectively.

5. The method of claim 4, wherein the switching means if a multiplexer.

6. The method of claim 5, wherein the local routing networks are multi-bit routing networks.
